# EUROPEAN PATENT APPLICATION

(11) **EP 4 712 503 A1**
(43) Date of publication of application: **18.03.2026**
(21) Application number: 23962950.4
(22) Date of filing: 29.12.2023
(51) Int. Cl.: H04R 1/10

(54) **ACOUSTIC APPARATUS**

(71) Applicant: Shenzhen Shokz Co., Ltd., Shenzhen, Guangdong 518108 (CN)
(72) Inventor: ZHOU, Wenbing, Shenzhen, Guangdong 518108 (CN); HUANG, Yujia, Shenzhen, Guangdong 518108 (CN); KE, Hao, Shenzhen, Guangdong 518108 (CN); ZHANG, Henghao, Shenzhen, Guangdong 518108 (CN); LIAO, Fengyun, Shenzhen, Guangdong 518108 (CN); QI, Xin, Shenzhen, Guangdong 518108 (CN)
(74) Representative: Wang, Bo
(86) International application number: PCT/CN2023/143664
(87) International publication number: WO 2025/138276

(57) **Abstract**

An acoustic device is provided. The acoustic device comprises a housing, a waterproof assembly, an acoustic assembly, a pressure-bearing device, and a sealing member. The housing includes an outer wall, an inner wall, and a sound transmission hole. The sound transmission hole penetrates through the housing and connects an internal space of the housing with an external space. The waterproof assembly is disposed in the internal space and covers the sound transmission hole to prevent liquid from entering the internal space from the external space. The acoustic assembly includes an acoustic sensor, and the acoustic assembly is disposed on a side of the waterproof assembly away from the sound transmission hole and is in sealed connection with the waterproof assembly. The acoustic assembly and the housing form a first gap. The pressure-bearing device covers the acoustic assembly, and the sealing member seals the first gap to prevent the liquid from entering the internal space through the first gap, thereby improving waterproof capability of the acoustic device.

## Description

### TECHNICAL FIELD

The present disclosure belongs to the technical field of electronic devices, and specifically relates to acoustic devices.

### BACKGROUND

A housing of an acoustic device is typically provided with a sound transmission hole that allows sound to pass from an external environment to an interior of the acoustic device or pass from the interior of the acoustic device to the external environment. When the acoustic device is used in an outdoor or humid environment, water may easily enter the acoustic device through the sound transmission hole. For example, for a microphone of a wireless earphone to capture ambient sound and ensure call quality, the wireless earphone is provided with the sound transmission hole to enable sound transmission via air conduction. However, when a user wears the wireless earphone during an underwater activity (e.g., swimming), water may enter the wireless earphone through the sound transmission hole. After water enters the wireless earphone, it may not only adversely affect the normal operation of internal components of the wireless earphone, e.g., causing a malfunction of a microphone or a speaker of the wireless earphone, but may also cause a short circuit in a circuit of a mainboard or other components, thereby preventing the user from normally using the earphone.

Therefore, existing acoustic devices require measures to enhance waterproof protection, particularly for components such as microphones and speakers.

### SUMMARY

To address the lack of waterproof protection in the existing acoustic devices, the present disclosure provides an acoustic device with improved waterproof performance. The present disclosure provides an acoustic device comprising a housing, a waterproof assembly, an acoustic assembly, a pressure-bearing device, and a sealing member. The housing includes an outer wall, an inner wall, and a sound transmission hole. The sound transmission hole penetrates through the housing and connects an internal space of the housing with an external space. The waterproof assembly is disposed in the internal space and covers the sound transmission hole to prevent liquid from entering the internal space from the external space. The acoustic assembly includes an acoustic sensor, and the acoustic assembly is disposed on a side of the waterproof assembly away from the sound transmission hole and is in sealed connection with the waterproof assembly. The acoustic assembly and the housing form a first gap. The pressure-bearing device covers the acoustic assembly, and the sealing member seals the first gap to prevent the liquid from entering the internal space through the first gap.

In some embodiments, when the pressure-bearing device is subjected to an external force in a first direction, the external force is transmitted to a target position of the waterproof assembly such that the waterproof assembly abuts against the inner wall.

In some embodiments, in a second direction perpendicular to the first direction, an outer edge dimension of the pressure-bearing device is greater than an outer edge dimension of the acoustic sensor.

In some embodiments, the waterproof assembly includes a waterproof membrane, a first adhesive portion located on a side of the waterproof membrane along the first direction, and a second adhesive portion located on another side of the waterproof membrane along the first direction. The first adhesive portion and the second adhesive portion are annular, and the target position includes annular regions formed by the first adhesive portion and the second adhesive portion.

In some embodiments, the first adhesive portion and the second adhesive portion are in a compressed state in the first direction.

In some embodiments, the housing includes a first accommodation cavity, and the waterproof assembly is disposed in the first accommodation cavity.

In some embodiments, the acoustic assembly further includes a circuit board, and the acoustic sensor is mechanically connected to the circuit board. The circuit board is mounted at an opening end of the first accommodation cavity and forms the first gap with the opening end.

In some embodiments, the pressure-bearing device is mounted at an opening end of the first accommodation cavity and forms a second gap with the opening end, and the sealing member is filled into the second gap.

In some embodiments, the pressure-bearing device includes a pressure-bearing shell and a second accommodation cavity, and the acoustic sensor is located in the second accommodation cavity. Along the first direction, the pressure-bearing shell includes a first end surface and a second end surface, the second end surface abuts against the circuit board, and the first end surface is away from the circuit board to receive an external force.

In some embodiments, the acoustic sensor includes at least one of a microphone or a speaker. The pressure-bearing device is made of a rigid material.

In some embodiments, the circuit board includes at least one positioning hole, and at least one positioning protrusion is provided on an end surface of the opening end and arranged around the opening end. Each of the at least one positioning protrusion corresponds to one of the at least one positioning hole, and the at least one positioning protrusion passes through the at least one positioning hole.

In some embodiments, the pressure-bearing device includes at least one positioning hole, and at least one positioning protrusion is provided on the inner wall. Each of the at least one positioning protrusion corresponds to one of the at least one positioning hole, and the at least one positioning protrusion passes through the at least one positioning hole.

In some embodiments, each of the at least one of the positioning protrusions includes an expanded end portion having a radial dimension larger than an aperture of the corresponding positioning hole, to secure the circuit board to an end surface of an opening end of a first accommodation cavity of the housing.

In some embodiments, there are two or more positioning protrusions, and the two or more positioning protrusions are uniformly arranged around a first accommodation cavity of the housing.

In some embodiments, an angle between a central axis of the sound transmission hole and the first direction is not less than 30° and not greater than 60°. The sound transmission hole includes a first opening on the outer wall and a second opening on the inner wall, and the second opening is smaller than the first opening. An average diameter of the sound transmission hole is in a range of 0.6-1.2 mm.

In some embodiments, the sealing member is formed by providing a fluid sealing material into the first gap and subsequently curing the fluid sealing material.

In some embodiments, the fluid sealing material is a sealant.

In some embodiments, the acoustic sensor includes a first acoustic sensor and a second acoustic sensor. The inner wall of the housing includes a housing bottom wall and a housing side wall. The housing bottom wall is provided with a third accommodation cavity for accommodating the first acoustic sensor, and the housing side wall is provided with a fourth accommodation cavity for accommodating the second acoustic sensor.

In the acoustic device described in the present disclosure, the waterproof assembly with sound transmission and waterproof functions is mounted over the second opening of the sound transmission hole to prevent liquids such as water from entering the housing. The pressure-bearing device evenly distributes the external force to the target position of the waterproof assembly, preventing wrinkles during installation of the waterproof assembly. This configuration ensures waterproof functionality without compromising acoustic performance, allowing the acoustic device to maintain both high waterproof integrity and excellent sound quality. Additionally, the sealing member is configured to seal the first gap between the acoustic assembly and the housing, further enhancing the waterproof performance.

Other functions of the waterproof assembly provided in the present disclosure will be **p**artially described in the following sections. The inventive aspects of the acoustic device disclosed herein may be fully explained through the practice or use of the methods, devices, and combinations set forth in the detailed examples below.

### BRIEF DESCRIPTION OF THE DRAWINGS

To more clearly illustrate the technical solutions of the embodiments of the present disclosure, a brief description of the drawings required for the description of the embodiments is provided below. It is apparent that the drawings described below are merely some embodiments of the present disclosure, and for those of ordinary skill in the art, other drawings may also be obtained based on these drawings without inventive effort.
FIG. 1 is a schematic diagram of an acoustic device according to some embodiments of the present disclosure;
FIG. 2 is a partial cross-sectional view of portion A of the acoustic device shown in FIG. 1;
FIG. 3 is a structural schematic diagram of components of an acoustic device according to some embodiments of the present disclosure; and
FIG. 4 is a structural schematic diagram of a pressure-bearing device according to some embodiments of the present disclosure.

### DETAILED DESCRIPTION

The following description provides specific application scenarios and requirements of the present disclosure, aiming to enable those skilled in the art to make and use the contents of the present disclosure. Various partial modifications to the disclosed embodiments will be obvious to those skilled in the art, and the general principles defined herein may be applied to other embodiments and applications without departing from the spirit and scope of the present disclosure. Therefore, the present disclosure is not limited to the embodiments shown but is to be accorded the widest scope consistent with the claims.

As indicated in the present disclosure and in the claims, the singular forms "a," "an," and "the" may be intended to include the plural forms as well, unless the context clearly indicates otherwise. In general, the terms "comprise," "comprises," and/or "comprising," "include," "includes," and/or "including," when used in this disclosure, specify the presence of stated features, integers, steps, operations, elements, and/or components, but do not preclude the presence or addition of one or more other features, integers, steps, operations, elements, components, and/or groups thereof.

In the present disclosure, terms such as "upper," "lower," "left," "right," "front," "rear," "top," "bottom," "inner," "outer," "vertical," "horizontal," "transverse," and "longitudinal" indicate orientations or positional relationships based on those shown in the accompanying drawings. These terms are used primarily to better describe the present disclosure and its embodiments and are not intended to limit the indicated devices, elements, or components to having a specific orientation or being constructed and operated in a specific orientation.

Moreover, in addition to indicating orientation or positional relationships, some of the above terms may also be used to express other meanings. For example, the term "upper" may in some cases be used to indicate a certain attachment or connection relationship. Those of ordinary skill in the art can understand the specific meanings of these terms in the present disclosure based on the context.

Furthermore, terms such as "mount," "set," "provided with," "connect," and "connected" should be interpreted broadly. For example, a connection may be a fixed connection, a detachable connection, or an integral structure; it may be a mechanical connection or an electrical connection; it may be a direct connection, an indirect connection through an intermediary, or an internal communication between two devices, elements, or components. Those of ordinary skill in the art can understand the specific meanings of the above terms in the present disclosure based on the context.

In the present disclosure, the expression "X comprises/includes at least one of A, B, or C" means that X includes at least A, or X includes at least B, or X includes at least C. In other words, X may include any one of A, B, or C alone, or any combination of A, B, and C, as well as other possible contents/elements. "Any combination of A, B, and C" may be A, B, C, AB, AC, BC, or ABC.

In the present disclosure, unless explicitly stated otherwise, an associative relationship between structures may be a direct relationship or an indirect relationship. For example, when describing "A is connected to B," unless it is explicitly stated that A is directly connected to B, it should be understood that A may be directly connected to B or indirectly connected to B. Similarly, when describing "A is above B," unless it is explicitly stated that A is directly above B (A and B are adjacent, and A is above B), it should be understood that A may be directly above B or indirectly above B (other elements exist between A and B, and A is above B). The same applies to other similar expressions.

Considering the following description, these and other features of the present disclosure, the operation and function of related elements of the structure, and the combination of parts and the economy of manufacturing may be significantly improved. All these form part of the present disclosure with reference to the accompanying drawings. However, it should be clearly understood that the drawings are for illustrative and descriptive purposes only and are not intended to limit the scope of the present disclosure. It should also be understood that the drawings are not drawn to scale.

The present disclosure is described in detail below through specific embodiments:
A housing of an acoustic device is typically provided with sound transmission holes that allow sound to pass from the external environment to an interior of the acoustic device or pass from the interior of the acoustic device to the external environment to. For example, to ensure call quality, a wireless earphone with call functionality includes a sound transmission hole for a microphone to capture sound via air conduction. To prevent liquid such as water from entering the acoustic device and ensure normal operation when used in an outdoor or humid environment, liquid protection measures for the sound transmission hole are necessary. The present disclosure provides an acoustic device, which has undergone liquid-resistant treatment at the sound transmission hole to enhance its waterproof capability. Liquids described herein include, but are not limited to, water, oil, sweat, or other liquids. For convenience of description, water is used as an example in the following descriptions.

The acoustic device may be any electronic device with sound-emitting functionality. Examples of the acoustic device include an earphone, a mobile phone, a computer, a voice recorder, or other electronic devices. For clarity of presentation, the following description uses earphones as an example of the acoustic device. It should be understood by those skilled in the art that other types of acoustic devices also fall within the scope of the present disclosure.

The earphones of the present disclosure may be of any type. Examples of the earphones may include a wired earphone, a wireless earphone, an air-conduction earphone, a bone-conduction earphone, a hybrid bone-conduction and air-conduction earphone, or the like. In some embodiments, the earphone may include a data storage unit. In such cases, the earphone may operate independently without relying on an external media player, play audio data stored in the built-in storage unit when no signal transmission with an external media player occurs. The types of earphones are not limited in the present disclosure.

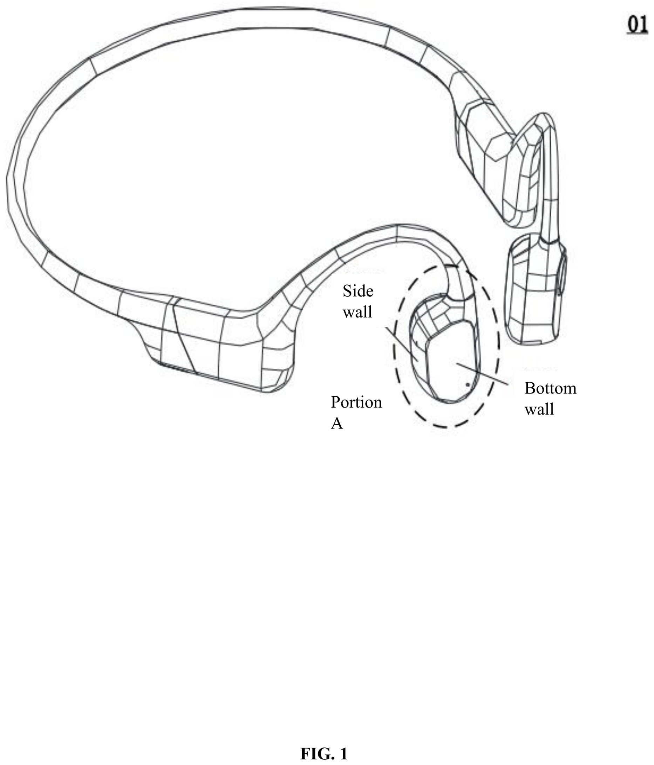

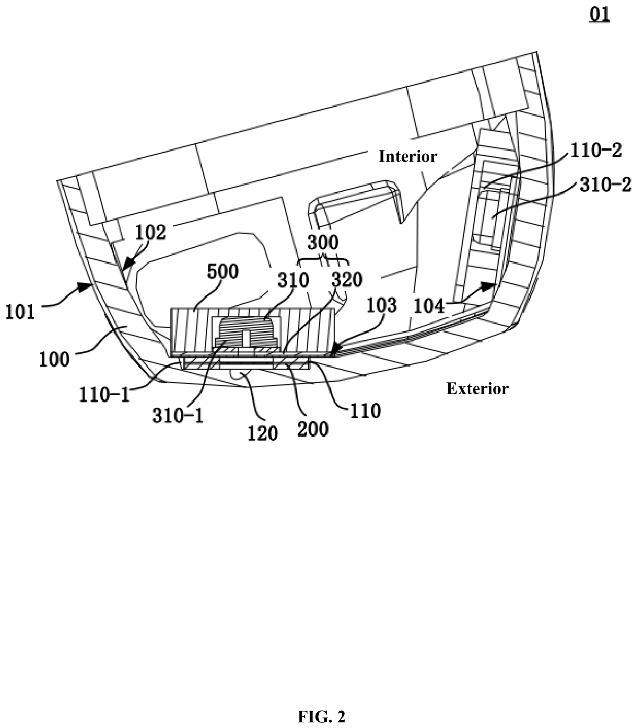

As an example, FIG. 1 illustrates a schematic diagram of an acoustic device 01 according to some embodiments of the present disclosure, and FIG. 2 illustrates a partial cross-sectional view of portion A of the acoustic device 01 shown in FIG. 1. FIG. 1 shows a structural schematic diagram of the acoustic device 01 (e.g., a wireless earphone). The acoustic device 01 (e.g., the wireless earphone) may include a housing 100, a waterproof assembly 200, an acoustic assembly 300, a pressure-bearing device 500, and a sealing member 400 (not shown in FIGS. 1 and 2).

The housing 100 may serve as a mounting base for the acoustic device 01. Referring to FIG. 2, other components (e.g., the waterproof assembly 200, the acoustic assembly 300, the pressure-bearing device 500, etc.) of the acoustic device 01 may be mounted with the housing 100 as a carrier. The housing 100 may have a thin-walled structure. The housing 100 may include an outer wall 101 and an inner wall 102. The outer wall 101 may be an exterior surface ultimately presented to a user. The outer wall 101 may be a smooth curved surface. The outer wall 101 and the inner wall 102 may be provided with grooves or protrusions to facilitate assembly. In some embodiments, the housing 100 may include two portions that are snapped together after other components are assembled, forming a functional component shown in portion A of FIG. 1 for the acoustic device 01. The housing 100 may be configured as any shape, such as a racetrack shape (rounded rectangle) or circular. When the acoustic device 01 is a wireless earphone, the housing 100 may be shaped to conform to a contour of ears of the user, enabling the wireless earphone to be worn securely on the ears of the user. The housing 100 may be made of any material, such as metal, plastic, polymer, etc. The present disclosure does not limit the shape or the material of the housing 100.

In some embodiments, the housing 100 may include a first accommodation cavity 110, allowing other components to be installed within the housing 100 to provide protection and fixation. The first accommodation cavity 110 may accommodate part or all of the waterproof assembly 200, the acoustic assembly 300, and the pressure-bearing device 500. For example, the waterproof assembly 200 may be entirely disposed within the first accommodation cavity 110. In some embodiments, the first accommodation cavity 110 may be formed by creating a groove on the inner wall 102 of the housing 100. In some embodiments, a partition plate may be provided on the inner wall 102 of the housing, and the partition plate and part of the inner wall 102 of the housing together enclose the first accommodation cavity 110.

As shown in FIG. 2, the inner wall 102 of the housing 100 may include a bottom wall 103. As illustrated in FIG. 1, the bottom wall 103 may be an inner surface of the bottom wall shown within the dashed box of the acoustic device 01 in FIG. 1. The bottom wall may be a thin-walled plate-like structure. The bottom wall 103 may be planar or curved. When the bottom wall 103 is curved, a center of curvature of the bottom wall 103 may be positioned away from the first accommodation cavity 110 to provide a better user experience when the user wears the acoustic device 01. Furthermore, a third accommodation cavity 110-1 may be provided on the bottom wall 103. The third accommodation cavity 110-1 may accommodate components of the acoustic device 01 that require separate protection. For example, the third accommodation cavity 110-1 may accommodate the acoustic assembly 300.

The inner wall 102 of the housing 100 may further include a side wall 104. As shown in FIG. 1, the side wall 104 may be an inner surface corresponding to the side wall within the dashed box. The side wall 104 is located on a side surface of the housing 100 and may be a thin-walled plate-like structure. The side wall 104 may be planar or curved. When the side wall 104 is curved, a center of curvature of the side wall 104 may be positioned away from the first accommodation cavity 110 to facilitate positioning during assembly if the housing 100 consists of two portions. Additionally, a fourth accommodation cavity 110-2 may be provided on the side wall 104. The fourth accommodation cavity 110-2 may accommodate components of the acoustic device 01 that require separate protection. For example, the fourth accommodation cavity 110-2 may accommodate the acoustic assembly 300.

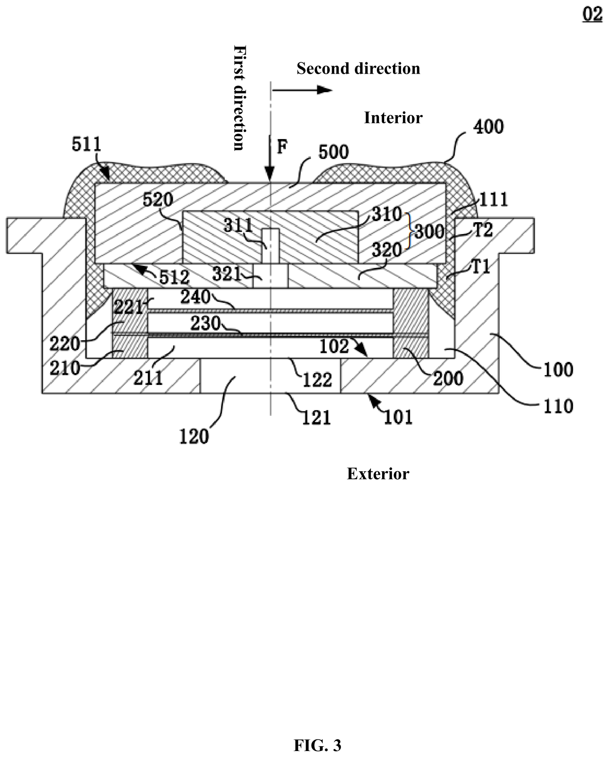

The housing 100 may include a sound transmission hole 120, which allows an external sound wave to enter the housing 100 and be captured by the acoustic assembly 300, or enables a sound wave generated by the acoustic assembly 300 to be transmitted to an external environment. The sound transmission hole 120 penetrates through the housing 100 and connecting an internal space of the housing 100 with an external space. As an example, FIG. 3 illustrates a schematic diagram of partial structures of the housing 100 of the acoustic device 01 according to some embodiments of the present disclosure. As shown in FIG. 3, the sound transmission hole 120 penetrates through the housing 100. The sound transmission hole 120 may include a first opening 121 on the outer wall 101 and a second opening 122 on the inner wall 102. The first opening 121 and the second opening 122 are exemplified as circular openings. In some embodiments, an aperture of the second opening 122 is smaller than an aperture of the first opening 121. The "aperture" refers to a diameter of the opening on the wall surface. In other words, the sound transmission hole 120 may have a flared shape that is wider externally and narrower internally. By designing the sound transmission hole 120 with the flared shape, it is not only convenient for the user to clean foreign matter such as solids or liquids entering the hole more conveniently, and but also ensures smooth demolding during a machining process of the sound transmission hole 120. The shape of the sound transmission hole 120 may be circular, elliptical, square, rectangular, or any other shape, and the present disclosure does not limit the specific shape of the sound transmission hole 120. The sound transmission hole 120 may be located on the bottom wall 103 or the side wall 104. For ease of illustration, the following description takes uses the sound transmission hole being disposed on the bottom wall 103 as an example.

In some embodiments, a central axis of the sound transmission hole 120 is perpendicular to the inner wall 102 of the housing 100 where the hole is formed. In other words, the central axis of the sound transmission hole 120 is perpendicular to the bottom wall 103 of the housing 100 where the hole is formed. Since the side wall and/or the bottom wall 103 of the housing 100 may be planar or curved, the term "perpendicular" in the present disclosure refers to being perpendicular to a tangential plane of a position on the inner wall 102 or the outer wall 101 where the sound transmission hole 120 is located. As shown in FIG. 3, the sound transmission hole 120 is perpendicular to the inner wall surface 102 and penetrates vertically downward through the housing 100, i.e., the sound transmission hole 120 is perpendicular to the bottom wall 103 and penetrates vertically downward through the housing 100. In some embodiments, the central axis of the sound transmission hole 120 may not be perpendicular to the inner wall 102 of the housing where the sound transmission hole 120 is formed. A tilt angle between the central axis of the sound transmission hole 120 and the inner wall 102 of the housing where the sound transmission hole 120 may be in a range of [30°, 90°). When the tilt angle is within [60°, 90°), it maintains a certain degree of inclination while also reducing the machining difficulty of the sound transmission hole 120. When the tilt angle is within [30°, 60°], keeping the tilt angle within this range can further enhance the ability to obstruct water from entering the interior of the housing 10 through the sound transmission hole 120. In some application scenarios, such as swimming, by tilting the sound transmission hole 120, when the acoustic device 01 is subjected to dynamic water pressure, water flow does not directly rush into the sound transmission hole 120, thereby improving the waterproof capability of the acoustic device 01 under dynamic water pressure. In some embodiments, the central axis of the sound transmission hole 120 may be perpendicular to the bottom wall 103 to reduce machining difficulty. The shape of the sound transmission hole 120 may be circular, elliptical, square, rectangular, or any other shape, and the present disclosure does not limit the shape of the sound transmission hole 120.

As shown in FIG. 2, the sound transmission hole 120 may penetrate through the housing 100 at an inclination relative to the inner wall 102. The central axis of the sound transmission hole 120 may be a line connecting a center of the second opening 122 on the inner wall 102 of the housing 100 and a center of the first opening 121 on the outer wall 101 of the housing 100. It should be noted that the term "perpendicular" mentioned above may mean essentially perpendicular or substantially perpendicular, allowing for a certain degree of tolerance. A magnitude of this tolerance depends on a precision of the sound transmission hole 120 and the housing 100.

The acoustic assembly 300 may be disposed between the pressure-bearing device 500 and the waterproof assembly 200. One end of the acoustic assembly 300 is connected to the pressure-bearing device 500, while the other end of the acoustic assembly 300 is connected to the waterproof assembly 200. By way of example, the acoustic assembly 300 may be in sealed connection with the waterproof assembly 200. For example, the sealing member 400 may be filled into a connection gap between the acoustic assembly 300 and the waterproof assembly 200 to achieve a sealing effect. As another example, the sealing member 400 may be filled into a connection gap between the acoustic assembly 300 and a side wall of the waterproof assembly 200 to achieve the sealing effect. Adhesion surfaces of the acoustic assembly 300 and the waterproof assembly 200 may be adhered using double-sided tape on the acoustic assembly and gel applied to a buffer layer of the waterproof assembly 200 to achieve sealing.

The acoustic assembly 300 is configured to capture or emit sound and should avoid contact with water. As an example, the acoustic assembly 300 may be disposed on a side of the waterproof assembly 200 away from the sound transmission hole 120. The waterproof assembly 200 can prevent water from entering the internal space of the housing, thereby avoiding contact between the acoustic assembly 300 and water.

Referring to FIG. 3, the acoustic assembly 300 may be at least partially disposed within the first accommodation cavity 110. A first gap T1 is formed between the acoustic assembly 300 and the housing 100, and the sealing member 400 may be filled into the first gap T1. The sealing member 400 filled into the first gap T1 not only secures the acoustic assembly 300 within the first accommodation cavity 110 but also prevents liquid from entering the interior of the housing 100 through the first gap T1, further enhancing the waterproofing effect. In some embodiments, the sealing member 400 may be formed by providing a fluid sealing material into the first gap T1 and subsequently curing the fluid sealing material. It should be noted that FIG. 3 only shows the position of the cured sealing material. The fluid sealing material can completely fill the entire gap through flow, so the components/structures connected by the sealing member 400 are in sealed connection. The fluid sealing material may be a sealant, such as an ultraviolet (UV) curable adhesive, a silicone adhesive, a hot melt adhesive, or the like. For example, UV curable adhesive may be filled into the first gap T1, and after curing, the first gap T1 is sealed, preventing liquid from entering the internal space through the first gap. The acoustic assembly 300 may include an acoustic sensor 310. The acoustic sensor 310 may receive or emit sound. By way of example, the acoustic sensor 310 may include at least one of a microphone or a speaker.

In some embodiments, the acoustic assembly 300 may include one acoustic sensor 310. In other embodiments, the acoustic assembly 300 may include a plurality of acoustic sensors 310 to enable additional functionalities. For example, when the acoustic sensors 310 are microphones, two microphones may be provided in the earphone to achieve a noise reduction effect. One microphone may be a conventional microphone used for user calls and configured to collect human voice. The other microphone may have a noise collection function, facilitating the collection of ambient noise. By way of example, FIG. 2 illustrates a schematic structural diagram of the acoustic assembly 300 comprising two acoustic sensors 310 according to some embodiments of the present disclosure. Referring to FIG. 2, the acoustic sensors 310 may include a first acoustic sensor 310-1 and a second acoustic sensor 310-2. The first acoustic sensor 310-1 and the second acoustic sensor 310-2 may be connected through a circuit board 320, meaning the circuit board 320 serves as a unified component connecting the two acoustic sensors 310 simultaneously. In some embodiments, the first acoustic sensor 310-1 and the second acoustic sensor 310-2 may also be connected to different circuit boards respectively. In such cases, as shown in FIG. 2, the third accommodation cavity 110-1 may accommodate the first acoustic sensor 310-1, while the fourth accommodation cavity 110-2 may accommodate the second acoustic sensor 310-2.

Referring to FIG. 3, the acoustic sensor 310 may include a hole 311. For example, the acoustic sensor 310 may include at least one microphone equipped with a hole 311 to receive ambient sound transmitted through the waterproof assembly 200. The acoustic sensor 310 may also include at least one speaker. A speaker includes a hole 311. During operation, the speaker may emit target sound, which may be output through the hole 311 and then transmitted outward through the waterproof assembly 200 of the acoustic device 01. The waterproof assembly 200 covers the sound transmission hole 120 to prevent liquid from penetrating through the waterproof assembly 200 and contacting components within the acoustic assembly 300. Specifically, the waterproof assembly 200 blocks liquid from penetrating through to contact the acoustic sensor 310, preventing liquid from entering the interior of the acoustic sensor 310 via the hole 311, thereby avoiding damage to the acoustic sensor 310 and preventing the acoustic performance of the acoustic device 01 from being affected.

The acoustic assembly 300 may further include a circuit board 320. The acoustic sensor 310 is connected to the circuit board 320. As an example, the acoustic sensor 310 may be mechanically connected to the circuit board 320. The mechanical connection between the acoustic sensor 310 and the circuit board 320 may be achieved through adhesion, Surface Mount Technology (SMT) placement, soldering, seam locking, riveting, etc. For example, the acoustic sensor 310 may be fixed to the circuit board 320 via soldering. As another example, an adhesive may be used to bond the acoustic sensor 310 to the circuit board 320.

The circuit board 320 may be positioned between the acoustic sensor 310 and the waterproof assembly 200. As shown in FIG. 3, the circuit board 320 may be plate-shaped and abut against an end face of the pressure-bearing device 500 facing the waterproof assembly 200. The circuit board 320 is mounted at an opening end of the first accommodation cavity 110 and forms the first gap T1 with the opening end. The circuit board 320 is an integrated circuit that incorporates functional chips of the acoustic device 01, enabling control of the acoustic sensor 310. In some embodiments, the circuit board includes a radio frequency (RF) unit for receiving and transmitting a signal, such as communication components like Bluetooth, NFC, Wi-Fi, etc., to facilitate communication with an external media player. In some embodiments, the circuit board includes a Central Processing Unit (CPU) for data processing and a Digital Signal Processor (DSP) for audio decoding. In some embodiments, the circuit board further includes a data storage unit for storing audio data. The circuit board may be used for short-range wireless communication, audio transmission, data transmission, data storage, location-based services, device networking, or the like. The present disclosure does not limit the type of the circuit board. Specifically, the circuit board may include a flexible printed circuit (FPC), a rigid printed circuit board (PCB), or a rigid-flex PCB. That is to say, the circuit board may be one or more of a circuit, a processor, etc., capable of performing one or more functions.

In some embodiments, one of the circuit board 320 and an end face of the opening end of the first accommodation cavity 110 may include a positioning hole 530, while the other includes a positioning protrusion 132. In some embodiments, the positioning hole 530 may be formed on the circuit board 320 to facilitate fixation of the circuit board 320. Specifically, the circuit board 320 includes at least one positioning hole 530 for positioning and mounting the circuit board 320. At least one positioning protrusion 132 is provided on the end surface of the opening end of the first accommodation cavity 110 and arranged around the opening end. Each of the at least one positioning protrusion 132 corresponds to one of the at least one positioning hole 530, and passes through the corresponding positioning hole 530. In some embodiments, there are two or more positioning protrusions 132, and the two or more positioning protrusions 132 are uniformly arranged around the first accommodation cavity 110 of the housing 100. Each of the at least one positioning protrusion 132 includes an expanded end portion having a radial dimension larger than an aperture of the corresponding positioning hole 530, to secure the circuit board 320 to the end surface of the opening end of the first accommodation cavity 110 of the housing 100. This arrangement allows the circuit board 320 to be positioned and further fixed to the inner wall of the housing 100 through a rigid connection between the positioning hole(s) 530 and the positioning protrusion(s) 130. With this arrangement, the circuit board 320 can be fixed to the housing 100 without applying or injecting a sealant onto the circuit board 320, thereby avoiding assembly failure caused by excessive overflow of the sealant and improving assembly efficiency. It should be noted that there may be one or more positioning holes 530 and one or more positioning protrusions 130, which is not limited herein.

As set forth, one end of the acoustic assembly 300 is connected to the waterproof assembly 200. For example, the acoustic assembly 300 may be bonded to an adhesive region of the waterproof assembly 200 to achieve connection. In some embodiments, a pressure jig may be used to apply a force F to the acoustic assembly 300, ensuring a secure bond between the circuit board 320 and the adhesive region of the waterproof assembly 200. In some embodiments, the circuit board 320 may undergo local or overall reinforcement treatment to increase a thickness or hardness of a local portion of the circuit board 320. For example, a steel plate or a polyimide (PI) reinforcement plate may be used to reinforce the FPC. PI is an abbreviation for polyimide, which is an engineering plastic with excellent mechanical properties, characterized by light weight, small thickness, and good flexibility. The circuit board 320 may include a hole 321. The second opening 122 of the sound transmission hole 120 on the inner wall of the housing 100, the hole 321, and the hole 311 may be coaxial to minimize a path for sound entering or exiting the acoustic device 01, thereby reducing energy loss. In some embodiments, an aperture of the hole 311 may be smaller than or equal to an aperture of the hole 321, and an aperture of the hole 321 may be smaller than an aperture of the sound transmission hole 120. Designing a relatively large aperture for the sound transmission hole 120 can improve sound pressure. For example, an average diameter of the sound transmission hole 120 may range from 0.6 mm to 1.2 mm, the aperture of the hole 321 may be 0.5 mm, and the aperture of the hole 311 may be 0.25 mm.

As previously described, the sound transmission hole 120 penetrates through the housing 100 and connects the internal space of the housing 100 with the external space. The waterproof assembly 200 may be disposed within the internal space and cover the sound transmission hole 120 to prevent liquid from entering the internal space from the external space.

As shown in FIG. 3, in some embodiments, the waterproof assembly 200 may further include a waterproof membrane 230, a first adhesive portion 210, and a second adhesive portion 220. The first adhesive portion 210 is located on a side of the waterproof membrane 230 along a first direction indicated in FIG. 3, while the second adhesive portion 220 is located on another side of the waterproof membrane 230 along the first direction. According to some embodiments of the present disclosure, both the first adhesive portion 210 and the second adhesive portion 220 are annular in shape, and the target position includes annular regions formed by the first annular portion and the second annular portion.

Referring to FIG. 3, the waterproof assembly 200 may be mounted over the second opening 122 of the sound transmission hole 120. The waterproof assembly 200 allows a sound wave to pass from the external space of the housing 100 into the internal space of the housing 100 while preventing liquid from entering the internal space from the external space. The acoustic assembly 300 is located within the internal space on the side of the waterproof assembly 200 away from the sound transmission hole 120, thereby avoiding direct contact with water and ensuring the acoustic performance of the acoustic assembly 300. By way of example, the liquid may be water. Of course, in addition to water, the liquid may also be other liquid substances, such as fruit juice, liquid adhesive, etc.

In some embodiments, a pressure jig may be used to apply a predetermined force F to the waterproof assembly 200 along the first direction, enabling the waterproof assembly 200 to adhere to an outer edge of the second opening 122. By way of example, the waterproof assembly 200 is sheet-like, and the first direction may be a normal direction of the waterproof assembly 200. That is to say, the predetermined force F is applied perpendicularly to the surface of the waterproof assembly 200. This approach avoids subjecting the waterproof assembly 200 to a lateral force, thereby preventing wrinkles in the waterproof assembly 200 that may compromise its waterproof performance.

As set forth, the acoustic assembly 300 may be connected to the waterproof assembly 200 by bonding to the adhesive region of the waterproof assembly 200. For example, the acoustic assembly 300 may be connected to the waterproof assembly 200 via the second adhesive portion 220. After the waterproof assembly 200 and the acoustic assembly 300 are installed in the first accommodation cavity 110, the waterproof assembly 200 may be connected to the first accommodation cavity 110 through the first adhesive portion 210. At this time, the first adhesive portion 210 and the second adhesive portion 220 are in a compressed state along the first direction. That is to say, when the acoustic device 01 is in normal operation, the first adhesive portion 210 and the second adhesive portion 220 remain in the compressed state along the first direction.

The waterproof membrane 230 may be a thin film made of a special material. A sound wave can pass through the waterproof membrane 230, but liquid (e.g., water) cannot. By way of example, the waterproof membrane 230 may be fabricated from a material with an equivalent microporous structure. The waterproof membrane 230 made of the material with the equivalent microporous structure allows air molecules to pass through the equivalent microporous structure, whereas water molecules cannot pass through the equivalent microporous structure. The equivalent microporous structure may be any structure that achieves the effect of using micropores without necessarily having regular micropores. Further, surface tension of the waterproof membrane 230 may cause water droplets to form a spherical shape on a surface of the waterproof membrane 230, thereby reducing a contact area between water molecules and the waterproof membrane 230 and further improving the waterproof performance of the waterproof membrane 230.

The first adhesive portion 210 is located on a side of the waterproof membrane 230 close to the sound transmission hole 120 along the first direction, and the first adhesive portion 210 is adhesive. In some embodiments, the first adhesive portion 210 may be annular and surround the second opening 122. One surface of the first adhesive portion 210 may abut against an outer edge of the waterproof membrane 230, and the other surface may abut against the outer edge of the second opening 122. The first adhesive portion 210 may be provided with a central hole 211. The central hole 211 may be a cylindrical hole, allowing the waterproof membrane 230 to uniformly withstand water pressure from water flowing in through the sound transmission hole 120, thereby preventing the waterproof membrane 230 from being damaged due to uneven water pressure, which may reduce or even fail the waterproof effect of the waterproof assembly 200. The shape of the central hole 211 may also be any other shape, such as oval, square, rectangular, etc., and the shape of the central hole 211 is not limited in the present disclosure. In some embodiments, the shape of the central hole 211 may match the shape of the sound transmission hole 120. The aperture of the sound transmission hole 120 may be less than or equal to an aperture of the central hole 211, so that a relatively large portion of the waterproof membrane 230 can withstand water pressure, thereby reducing the risk of damage. For example, the aperture of the central hole 211 may be in a range of 0.8 mm to 1.8 mm. For example, the aperture of the central hole 211 may be 0.8 mm, 1 mm, 1.2 mm, 1.4 mm, 1.6 mm, 1.8 mm, or any other value between any two of these values. The average diameter of the sound transmission hole 120 may be in a range of 0.6 mm to 1.2 mm. For example, the aperture of the sound transmission hole 120 may be 0.6 mm, 0.8 mm, 1.0 mm, 1.2 mm, or any other value between any two of these values. The first adhesive portion 210 may further be elastic. Due to its elasticity, the first adhesive portion 210 can uniformly distribute high-speed physical pressure (impact energy). Since the first adhesive portion 210 is elastic, it can protect the waterproof membrane 230 from wrinkling due to significant impact during installation of the waterproof assembly 200, thereby preserving its acoustic performance. For example, the first adhesive portion 210 may be made from a material such as foam adhesive or elastic acrylic adhesive.

The second adhesive portion 220 is located on another side of the waterproof membrane 230 away from the sound transmission hole 120 along the first direction. In some embodiments, the second adhesive portion 220 may be annular. A central hole 221 may be formed in the second adhesive portion 220. A sound wave passing through the waterproof membrane 230 is collected by the acoustic assembly via the central hole 221. The second adhesive portion 220 is adhesive. One surface of the second adhesive portion 220 may be bonded to an edge region on the side of the waterproof membrane 230 away from the sound transmission hole 120, and the other surface of the second adhesive portion 220 may be bonded to the acoustic assembly 300. The second adhesive portion 220 may also be elastic. Due to its elasticity, the second adhesive portion 220 can uniformly distribute high-speed physical pressure (impact energy). Since the second adhesive portion 220 is also elastic, it can protect the waterproof membrane 230 from wrinkling due to significant impact during installation of the waterproof assembly 200, thereby preserving its acoustic performance. In some embodiments, the second adhesive portion 220 may be made from a material such as foam adhesive, foam with acrylic adhesive (acrylate adhesive), or acrylic adhesive (acrylate adhesive).

In some embodiments, the waterproof assembly 200 may further include a mesh screen 240. As shown in FIG. 3, the mesh screen 240 may be disposed on the side of the waterproof assembly 200 away from the sound transmission hole 120. When the waterproof membrane 230 is subjected to high water pressure, it may deform. In this case, the mesh screen 240 can provide support or act as a barrier behind the waterproof membrane 230, thereby preventing excessive deformation of the waterproof membrane 230. This avoids alterations to the acoustic performance of the waterproof membrane 230 and enhances the waterproof capability of the waterproof membrane 230. In this configuration, the second adhesive portion 220 may be bonded to the mesh screen 240. A side of the mesh screen 240 facing the acoustic assembly 300 may be fixed to the acoustic assembly 300 by adhesion. In some embodiments, the mesh screen 240 may also be disposed on a side of the waterproof assembly 200 close to the sound transmission hole 120 (not shown in the drawings). When the user wears the earphone for an underwater activity, water flow may enter the acoustic device 01 through the sound transmission hole 120. In this case, the water flow first passes through the mesh screen 240. The mesh screen 240 can disperse the water flow through its mesh pores, thereby distributing an impact force on the waterproof membrane 230 more evenly. Consequently, stress on various parts of the waterproof membrane 230 is reduced, making it less prone to deformation and thus enhancing the waterproof capability of the waterproof membrane 230 (and the waterproof assembly 200).

To minimize the impact on acoustic performance, the waterproof membrane 230 is typically very thin. Combined with the inherent material properties of the waterproof membrane 230 itself, any uneven external force may cause the waterproof membrane 230 to wrinkle. Once the waterproof membrane 230 becomes wrinkled, the acoustic performance of the acoustic device 01 is affected. This places high demands on the installation of the waterproof membrane 230-during the installation process, it is essential to avoid causing wrinkles in the waterproof membrane 230.

In some embodiments, during the installation of the waterproof assembly 200, the waterproof assembly 200 may first be placed into the first accommodation cavity 110, then the acoustic assembly 300 may be stacked on the waterproof assembly 200. A pressure jig is used to apply a force F along the normal direction (i.e., the first direction) of the waterproof assembly 200 to the acoustic sensor 310 within the acoustic assembly 300. The circuit board 320 connected to the acoustic sensor 310 transmits the force F downward to the waterproof assembly 200. As the waterproof assembly 200 is compressed, one side of it becomes tightly bonded to the circuit board 320, while the other side becomes tightly bonded to the edge of the second opening 122.

In the above installation process, the force F applied by the pressure jig is concentrated on an upper surface of the acoustic sensor 310. The force F is then transmitted downward through the acoustic sensor 310 to the circuit board 320 and finally applied to an outer edge of the waterproof assembly 200. Typically, a size of the acoustic sensor 310 is smaller than a size of the circuit board 320 and a size of the waterproof assembly 200. This means that an area (also referred to as a force-bearing area) over which the acoustic assembly 300 receives the force F from the pressure jig is relatively small, while the force is ultimately transferred to the edge region of the waterproof assembly 200, which has a larger force-bearing area than the acoustic assembly 300. During this process, even a slight deformation in the acoustic assembly 300 may directly lead to uneven pressure being applied to the edge of the waterproof assembly 200, thereby causing the waterproof membrane 230 to wrinkle. For example, it may directly result in uneven force distribution on the first adhesive portion 210 and the second adhesive portion 220 of the waterproof assembly 200, affecting the waterproof membrane 230 located between them and causing the waterproof membrane 230 to wrinkle and deform. This issue is particularly pronounced when the circuit board 320 is a flexible circuit board. When a force is applied to the acoustic sensor 310, the edge of the flexible circuit board is also highly susceptible to deformation.

To prevent the aforementioned issue, the acoustic device 01 provided in the present disclosure further includes a pressure-bearing device 500. The pressure-bearing device 500 covers the acoustic assembly 300. When the pressure-bearing device 500 is subjected to an external force in the first direction, the external force is transmitted to the target position of the waterproof assembly 200, such that the waterproof assembly abuts against the inner wall 102. For example, as shown in FIG. 3, when a force F is applied to the pressure-bearing device 500 along the first direction, the pressure-bearing device 500 can uniformly distribute the force F to the target position of the waterproof assembly 200. By way of example, the target position includes the outer edge of the waterproof assembly 200. The pressure-bearing device 500 helps evenly transmit the force F, thereby preventing the waterproof assembly 200 from wrinkling. In some embodiments, the pressure-bearing device 500 is made of a rigid material. The rigid material may include a hard plastic or a hard alloy. Using the rigid material for the pressure-bearing device 500 prevents the pressure-bearing device 500 from deforming under the force F, thereby avoiding uneven force distribution on the target position of the acoustic assembly 300. The first direction refers to the first direction indicated in FIG. 3.

Referring to FIG. 3, the pressure-bearing device 500 may be columnar in shape. The pressure-bearing device 500 may include a second accommodation cavity 520. The acoustic sensor 310 may be located within the second accommodation cavity 520. The pressure-bearing device may be hat-shaped, covering the acoustic assembly 300. For example, the acoustic sensor 310 may be mounted within the second accommodation cavity 520 to save space. In some embodiments, in a second direction perpendicular to the first direction, an outer edge dimension of the pressure-bearing device 500 is greater than an outer edge dimension of the acoustic sensor 310. In some embodiments, in the second direction, the outer edge dimension of the pressure-bearing device 500 is greater than an outer edge dimension of the waterproof assembly 200. As described previously, the first direction refers to the normal direction of the waterproof membrane, and the second direction is perpendicular to the first direction, e.g., the second direction is parallel to the waterproof membrane 230. With this configuration, when the pressure jig applies a force, the pressure-bearing device 500, which has a larger outer edge dimension, receives the force and uniformly transmits the force to the acoustic assembly 300, preventing deformation of the acoustic assembly 300 from affecting the waterproof membrane.

In some embodiments, as shown in FIG. 3, the pressure-bearing device 500 may be mounted at the opening end of the first accommodation cavity 110. A second gap T2 is formed between the pressure-bearing device 500 and an opening 111 of the opening end, and the sealing member 400 may be filled into the second gap T2. By way of example, the waterproof assembly 200 may first be placed into the first accommodation cavity 110, followed by sequentially stacking the acoustic assembly 300 and then the pressure-bearing device 500. A pressure jig is used to apply a force F to the pressure-bearing device 500, compressing the first adhesive portion 210 and the second adhesive portion 220 of the waterproof assembly 200. The force F is maintained for a period of time, and the sealing member 400 such as a fluid sealant is applied or filled into the opening 111. The sealing member 400 may flow through the second gap T2 and into the first gap T1. In other words, the sealing member 400 can simultaneously seal both the first gap T1 and the second gap T2, thereby preventing water from entering the internal space of the housing 100 via the first gap T1 and the second gap T2.

Under the force F applied by the pressure jig, an end of the pressure-bearing device 500 (the end closer to the sound transmission hole 120 in the drawing) moves into the first accommodation cavity 110 along the first direction from the opening 111. If the second gap T2 is too large, the pressure-bearing device 500 may shift laterally, potentially causing the waterproof assembly 200 to wrinkle. By way of example, the second gap T2 is configured not to exceed a predetermined value (e.g., 0.5 mm) to restrict the position offset of the pressure-bearing device 500 along the second direction. The second direction is perpendicular to the first direction. It should be noted that the second direction may be any direction perpendicular to the first direction. The second direction shown in FIG. 3 is merely exemplary. Those skilled in the art may understand that other directions different from the direction shown in FIG. 3 but still perpendicular to the first direction fall within the scope of the present disclosure. For example, the second direction may be opposite to the direction shown in FIG. 3 but still perpendicular to the first direction.

In some embodiments, the pressure-bearing device 500 further includes a pressure-bearing shell 510. Along the first direction, the pressure-bearing shell 510 may include a first end surface 511 and a second end surface 512. The first end surface 511 is away from the circuit board 320 and configured to receive the external force F. In some embodiments, after assembly is completed, the first end surface 511 may be entirely located within the first accommodation cavity 110, meaning the first end surface 511 is below or flush with the opening 111 of the first accommodation cavity 110. In other embodiments, after assembly, the first end surface 511 may be higher than the opening 111 of the opening end of the first accommodation cavity 110. The second end surface 512 may abut against the circuit board 320. By way of example, the second end surface 512 and the circuit board 320 may be sealingly connected.

In the embodiments illustrated in FIG. 3, the pressure jig applies the force F to a central region of the first end surface 511 of the pressure-bearing device 500 along the first direction. The pressure-bearing device 500 first distributes the force F uniformly to all its parts, particularly to the second end surface 512 in contact with the circuit board 320. Consequently, the force F is transmitted evenly to the circuit board 320 and finally to the outer edge of the waterproof assembly 200 in a uniform manner. When the waterproof assembly 200 reaches a required compression amount, the pressure jig is held stationary. A fluid sealant is then applied or filled into the gap (i.e., the second gap T2) between the pressure-bearing device 500 and the opening 111 of the first accommodation cavity 110, thereby sealing the gap and simultaneously secures the pressure-bearing device 500 in place. In some embodiments, to enhance the sealing effect and strengthen the fixation of the pressure-bearing device 500, the sealant may also be applied onto the first end surface 511 of the pressure-bearing device 500.

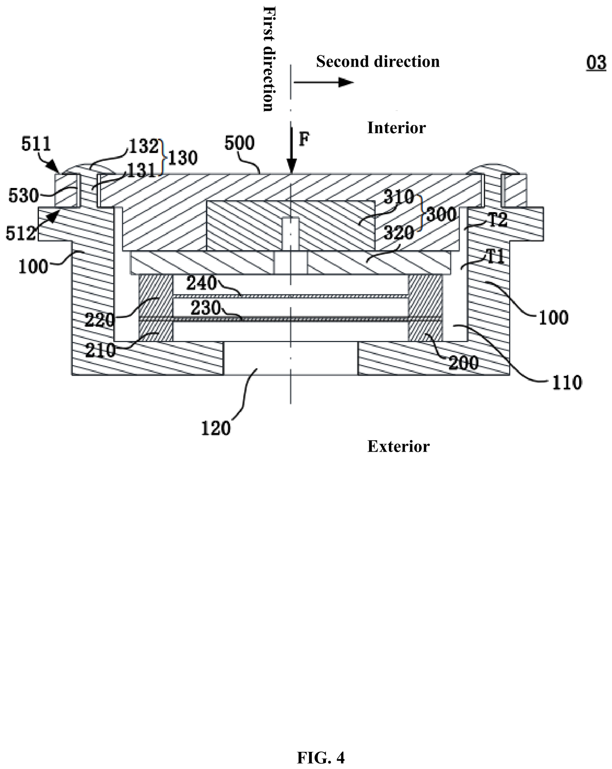

By way of example, FIG. 4 shows structural schematic diagram of another pressure-bearing device 500 according to some embodiments of the present disclosure.

Referring to FIG. 4, in some embodiments, the pressure-bearing device 500 may be shaped like a "hat with a brim". The pressure-bearing device 500 may include a main body portion and a peripheral portion. The main body portion is located at a center of the pressure-bearing device and configured to receive the force from the pressure jig. The peripheral portion is located at a periphery of the main body portion, annularly surrounding the main body portion, similar to a hat brim. An annular shape formed by the peripheral portion surrounding the main body portion may be a circular ring, a square ring, a triangular ring, or any other shape, which is not limited in the present disclosure.

In some embodiments, one of the pressure-bearing device 500 and the inner wall 102 of the housing 100 may include a positioning hole 530, and the other may include a positioning protrusion 132, so as to secure the pressure-bearing device 500 to the inner wall 102 of the housing 100. The positioning hole 530 may be provided on the pressure-bearing device 500, and the positioning protrusion 132 may be provided on the inner wall 102 of the housing 100. Alternatively, the positioning hole 530 may be provided on the inner wall 102 of the housing 100, and the positioning protrusion 132 may be provided on the pressure-bearing device 500. For ease of illustration, the following description assumes that the positioning hole 530 is provided on the pressure-bearing device 500 and the positioning protrusion 132 is provided on the inner wall 102 of the housing 100. Those skilled in the art may understand that other configurations also fall within the scope of the present disclosure.

Referring to FIG. 4, the pressure-bearing device 500 includes a positioning hole 530. A positioning protrusion 130 is provided on the inner wall 102 of the housing 100. The positioning hole 530 and the positioning protrusion 130 are matched to each other. The matching may mean that the shape and size of mating surfaces of the positioning hole 530 and the positioning protrusion 130 are matched. When the pressure-bearing device 500 cooperates with the inner wall 102, the positioning protrusion 130 passes through the positioning hole 530. The positioning hole 530 serves a guiding function, allowing the positioning protrusion 130 to be installed along the positioning hole 530. A cross-sectional shape of the positioning hole 530 may be triangular, rectangular, dovetail-shaped, circular, etc. There may be one or more positioning holes 530 and one or more positioning protrusions 130. In some embodiments, two or more positioning protrusions 132 may be uniformly arranged around the first accommodation cavity 110.

Furthermore, the aforementioned positioning protrusion 132 includes an expanded end portion 132 to secure the pressure-bearing device 500 to the inner wall 102 of the housing 100. A radial dimension of the expanded end portion 132 is larger than an aperture of the positioning hole 530, thereby fixing the pressure-bearing device 500 to the inner wall 102. In this way, the rigid connection between the positioning hole 530 and the positioning protrusion 130 enables positioning of the pressure-bearing device 500, further securing the pressure-bearing device 500 to the inner wall of the housing 100. With this arrangement, it is not necessary to apply or fill sealant onto the first end surface 511 of the pressure-bearing device 500 to fix the pressure-bearing device 500 to the housing, which avoids assembly failures caused by excessive adhesive overflow when the pressure jig is adhered to the pressure-bearing device, thereby improving assembly efficiency.

Furthermore, the required compression amount for the waterproof assembly 200 may be determined based on a difference between a total height of the pressure-bearing device 500, the acoustic assembly 300, and the waterproof assembly 200 in an uncompressed state and a total height of the pressure-bearing device 500, the acoustic assembly 300, and the waterproof assembly 200 in a compressed state. Then a height of the first accommodation cavity 110 may be rationally designed so that, in the uncompressed state, the second end surface 512 of the pressure-bearing device 500 is elevated above the inner wall 102 of the housing by a predetermined distance. That is to say, in the uncompressed state, the predetermined distance is maintained between the second end surface 512 of the pressure-bearing device 500 and the inner wall 102 of the housing. The predetermined distance may correspond to the required compression amount of the waterproof assembly 200. With this arrangement, simply pressing down the pressure-bearing device 500 until the second end surface 512 abuts against the edge of the first accommodation cavity 110 can compress the waterproof assembly 200 to a target state. This operation is simple, offers high precision, improves efficiency, and reduces costs.

In some embodiments, the positioning protrusion 130 may be made of a heat-fusible material. The end of the positioning protrusion 130 is heated and pressed to form the aforementioned expanded end portion 132. By way of example, the positioning protrusion 130 includes a rod portion 131, and a top end of the rod portion 131 is thermally melted and pressed to form the expanded end portion 132. Using the heat-melting and pressing manner, the positioning protrusion 130 forms a rivet-like structure that secures the pressure-bearing device 500 to the housing 100. This approach is not only simple and efficient, but the heat-fusible material also simultaneously seals a gap between the positioning protrusion 130 and the positioning hole 530, thereby eliminating the need for a separate sealing operation for the gap between the positioning protrusion 130 and the positioning hole 530, simplifying the operation, improving efficiency, and reducing costs.

In some embodiments, the housing 100 may further include one or more channels. After the waterproof assembly 200, the acoustic assembly 300, and the pressure-bearing device 500 are secured to the inner wall 102 of the housing 100 (e.g., within the first accommodation cavity 110), the sealing member 400 may be filled into the first gap T1 and the second gap T2 through the one or more channels. In some embodiments, the one or more channels may be disposed on the housing 100, for example, on the bottom wall 103 or the side wall 104 of the housing. In some embodiments, the channel(s) may be disposed on the pressure-bearing device 500, for example, in an edge region of the first end surface 511 of the pressure-bearing device 500. In some embodiments, the gap formed between the assembled pressure-bearing device 500 and the housing 100 constitutes part or all of the channel(s).

In summary, the present disclosure provides the acoustic device 01 with waterproof capability. The waterproof assembly 200 is disposed at the sound transmission hole communicating with the internal space of the housing. The waterproof assembly 200 covers the second opening 122 of the sound transmission hole 120, preventing liquid from entering the sound transmission hole 311 of the acoustic sensor 310 and avoiding ingress of water or other liquid into the interior of the housing, thereby ensuring the acoustic performance of the acoustic sensor 310. By using the pressure-bearing device 500 to uniformly distribute the external force to the target position of the waterproof assembly 200, wrinkling of the waterproof assembly 200 during installation is prevented. This ensures waterproof functionality while avoiding adverse effects on the acoustic performance due to wrinkling, allowing the acoustic device 01 to achieve both waterproofing and high acoustic quality. The sealing member 400 is used to seal the first gap T1 between the acoustic assembly 300 and the housing 100, and the second gap T2 between the pressure-bearing device 500 and the housing 100, further enhancing the waterproof performance and providing protection for other components and circuits within the housing 100. Through the aforementioned design, the waterproof capability of the acoustic device 01 is improved, and its acoustic performance is ensured.

The foregoing has described specific embodiments of the present disclosure. Other embodiments fall within the scope of the appended claims. In some instances, the operations or steps recited in the claims may be performed in an order different from that in the embodiments and still achieve desirable results. In addition, the processes depicted in the accompanying drawings do not necessarily require the illustrated specific or sequential order to achieve desirable results. In some embodiments, multitasking and parallel processing may be feasible and potentially advantageous.

In summary, after reading this detailed disclosure, those skilled in the art may understand that the foregoing detailed description is presented by way of example only and is not limiting. Although not explicitly stated herein, it should be understood that the present disclosure is intended to cover various reasonable changes, modifications, and adaptations to the embodiments. Such changes, modifications, and adaptations are intended to be proposed under the present disclosure and fall within the scope of the exemplary embodiments of the present disclosure.

Furthermore, certain terms in the present disclosure have been used to describe its embodiments. For example, "one embodiment," "an embodiment," and/or "some embodiments" indicate that a specific feature, structure, or characteristic described in connection with the embodiment may be included in at least one embodiment of the present disclosure. Thus, it is emphasized and should be understood that two or more references to "an embodiment," "one embodiment," or "an alternative embodiment" in various parts of the present disclosure do not necessarily all refer to the same embodiment. Additionally, specific features, structures, or characteristics may be combined appropriately in one or more embodiments of the present disclosure.

It should be understood that in the foregoing description of the embodiments of the present disclosure, various features have been combined into a single embodiment, figure, or description for the purpose of simplifying the disclosure and aiding in the understanding of individual features. However, this is not to imply that the combination of these features is necessary. Those skilled in the art, upon reading the present disclosure, may well extract some of these features to understand them as separate embodiments. In other words, the embodiments in the present disclosure may also be interpreted as integrations of multiple sub-embodiments. The content of each sub-embodiment remains valid even when it comprises fewer than all the features of any single previously disclosed embodiment.

Every patent, patent application, publication of a patent application, and other materials cited herein-such as articles, books, specifications, publications, documents, items, etc.-may be incorporated by reference. The entire content of these materials is incorporated for all purposes, excluding any related prosecution history that may be inconsistent with or conflict with the present disclosure, or any such prosecution history that might have a limiting effect on the broadest scope of the claims, whether now or in the future associated with the present disclosure. By way of example, if there is any inconsistency or conflict between the description, definition, and/or use of a term in any incorporated material and the term's description, definition, and/or use in the present disclosure, the term as used in the present disclosure shall prevail.

Finally, it should be understood that the embodiments of the present disclosure disclosed herein are illustrative of the principles of the embodiments of the present disclosure. Other modified embodiments also fall within the scope of the present disclosure. Accordingly, the embodiments disclosed in the present disclosure are by way of example only and not limitation. Those skilled in the art may adopt alternative configurations based on the embodiments herein to implement the present disclosure. Thus, the embodiments of the present disclosure are not limited to those precisely as described in the present disclosure.

## Claims

1. An acoustic device, comprising:
a housing including an outer wall, an inner wall, and a sound transmission hole, wherein the sound transmission hole penetrates through the housing and connects an internal space of the housing with an external space;
a waterproof assembly disposed in the internal space and covering the sound transmission hole to prevent liquid from entering the internal space from the external space;
an acoustic assembly including an acoustic sensor, wherein the acoustic assembly is disposed on a side of the waterproof assembly away from the sound transmission hole and is in sealed connection with the waterproof assembly, and the acoustic assembly and the housing form a first gap;
a pressure-bearing device covering the acoustic assembly; and
a sealing member sealing the first gap to prevent the liquid from entering the internal space through the first gap.

2. The acoustic device of claim 1, wherein when the pressure-bearing device is subjected to an external force in a first direction, the external force is transmitted to a target position of the waterproof assembly such that the waterproof assembly abuts against the inner wall.

3. The acoustic device of claim 2, wherein in a second direction perpendicular to the first direction, an outer edge dimension of the pressure-bearing device is greater than an outer edge dimension of the acoustic sensor.

4. The acoustic device of any one of claims 1 to 3, wherein the waterproof assembly includes:
a waterproof membrane;
a first adhesive portion located on a side of the waterproof membrane along the first direction; and
a second adhesive portion located on another side of the waterproof membrane along the first direction, wherein
the first adhesive portion and the second adhesive portion are annular, and
the target position includes annular regions formed by the first adhesive portion and the second adhesive portion.

5. The acoustic device of claim 4, wherein the first adhesive portion and the second adhesive portion are in a compressed state in the first direction.

6. The acoustic device of any one of claims 1 to 5, wherein the housing includes a first accommodation cavity, and the waterproof assembly is disposed in the first accommodation cavity.

7. The acoustic device of claim 6, wherein the acoustic assembly further includes a circuit board, and the acoustic sensor is mechanically connected to the circuit board; and
the circuit board is mounted at an opening end of the first accommodation cavity and forms the first gap with the opening end.

8. The acoustic device of claim 6 or claim 7, wherein the pressure-bearing device is mounted at an opening end of the first accommodation cavity and forms a second gap with the opening end, and the sealing member is filled into the second gap.

9. The acoustic device of claims 6 or 7, wherein the pressure-bearing device includes a pressure-bearing shell and a second accommodation cavity, and the acoustic sensor is located in the second accommodation cavity; and
along the first direction, the pressure-bearing shell includes a first end surface and a second end surface, the second end surface abuts against the circuit board, and the first end surface is away from the circuit board to receive an external force.

10. The acoustic device of any one of claims 1 to 9, wherein the acoustic sensor includes at least one of a microphone or a speaker; and
the pressure-bearing device is made of a rigid material.

11. The acoustic device of any one of claims 7 to 10, wherein the circuit board includes at least one positioning hole; and
at least one positioning protrusion is provided on an end surface of the opening end and arranged around the opening end, each of the at least one positioning protrusion corresponds to one of the at least one positioning hole, and the at least one positioning protrusion passes through the at least one positioning hole.

12. The acoustic device of any one of claims 1 to 10, wherein the pressure-bearing device includes at least one positioning hole; and
at least one positioning protrusion is provided on the inner wall, each of the at least one positioning protrusion corresponds to one of the at least one positioning hole, and the at least one positioning protrusion passes through the at least one positioning hole.

13. The acoustic device of claim 11 or claim 12, wherein each of the at least one of the positioning protrusions includes an expanded end portion having a radial dimension larger than an aperture of the corresponding positioning hole, to secure the circuit board to an end surface of an opening end of a first accommodation cavity of the housing.

14. The acoustic device of claim 11 or 12, wherein there are two or more positioning protrusions, and the two or more positioning protrusions are uniformly arranged around a first accommodation cavity of the housing.

15. The acoustic device of any one of claims 2 to 14, wherein an angle between a central axis of the sound transmission hole and the first direction is not less than 30° and not greater than 60°;
the sound transmission hole includes a first opening on the outer wall and a second opening on the inner wall, and the second opening is smaller than the first opening; and
an average diameter of the sound transmission hole is in a range of 0.6-1.2 mm.

16. The acoustic device of any one of claims 1 to 15, wherein the sealing member is formed by providing a fluid sealing material into the first gap and subsequently curing the fluid sealing material.

17. The acoustic device of claim 16, wherein the fluid sealing material is a sealant.

18. The acoustic device of any one of claims 1 to 17, wherein
the acoustic sensor includes a first acoustic sensor and a second acoustic sensor,
the inner wall of the housing includes a housing bottom wall and a housing side wall,
the housing bottom wall is provided with a third accommodation cavity for accommodating the first acoustic sensor; and
the housing side wall is provided with a fourth accommodation cavity for accommodating the second acoustic sensor.
